# EUROPÄISCHE PATENTSCHRIFT

(11) **EP 3 457 369 B1**
(45) Veröffentlichungstag und Bekanntmachung des Hinweises auf die Patenterteilung: **19.05.2021**
(21) Anmeldenummer: 17191826.1
(22) Anmeldetag: 19.09.2017
(51) Int. Cl.: G08B 17/10, G08B 17/103, G08B 17/107, G08B 17/113, G08B 29/04, G08B 29/14, H03F 3/08

(54) **SCHALTUNGSANORDNUNG FÜR EINEN RAUCHSENSOR**
CIRCUIT ARRANGEMENT FOR A SMOKE SENSOR
CIRCUIT POUR CAPTEUR DE FUMÉE

(43) Veröffentlichungstag der Anmeldung: 20.03.2019
(73) Patentinhaber: Elmos Semiconductor SE, 44227 Dortmund (DE)
(72) Erfinder: Arnold, Rüdiger, 10405 Berlin (DE)
(74) Vertreter: Durm Patentanwälte PartG mbB

(56) Entgegenhaltungen:
- EP-A1- 2 273 466
- DE-B3-102008 053 293
- US-A1- 2013 181 111
- US-A1- 2014 252 212
- US-B1- 8 547 170

## Beschreibung

Die vorliegende Erfindung betrifft eine Schaltungsanordnung für einen Rauchsensor, der auf einem optischen Messsystem basiert und bei dem von einem Sender ein Signal in eine Messkammer ausgesendet wird, das nach Durchgang durch die Messkammer von einem Empfänger empfangen wird.

Derartige Rauchsensoren oder Rauchmelder sind prinzipiell bekannt. Ein Sender sendet ein Sendesignal in eine Messkammer, die von Umgebungsluft durchströmt wird. Das Signal ist in der Regel ein Lichtsignal im sichtbaren oder unsichtbaren Bereich. Es können auch mehrere Lichtimpulse in einer periodischen Pulsfolge ausgesendet werden.

Die ausgesendeten Signale werden nach Durchgang durch die Messkammer von einer Photodiode empfangen. Abhängig von dem Medium in der Messkammer ändert sich das Empfangssignal. So können auf bekannte Weise Rauch oder andere Stoffe in der Messkammer festgestellt und detektiert werden.

Zwar ist eine möglichst engmaschige Überwachung der Raumluft und damit der Luft in der Messkammer wünschenswert. Allerdings hat sich ein kontinuierliches Überwachen zum einen als unnötig erwiesen, zum anderen würde eine kontinuierliche Überwachung einen hohen Energiebedarf erfordern. Aus diesem Grund besteht zwischen den einzelnen Lichtimpulsen oder Sendesignalen ein größerer zeitlicher Abstand von bis zu einigen Sekunden. Innerhalb dieser Zeitspanne wird kein Lichtimpuls ausgesendet. Es erfolgt keine Messung, da lediglich die dunkle Messkammer ausgemessen und ein sogenannter Dunkelstrom am Empfängerausgang gemessen werden könnte.

Der Energiebedarf spielt insbesondere bei batteriebetriebenen Rauchsensoren eine entscheidende Rolle. Aufgrund der Größe des Sensors ist auch die Größe der Batterie beschränkt. Damit ist die zur Verfügung stehende Energiemenge ebenfalls begrenzt. Bei handelsüblichen Rauchsensoren im Haushalt wird typischerweise eine 9-Volt-Blockbatterie eingesetzt. Ihre Lebensdauer soll jedoch möglichst mehrere Jahre halten.

Um energieeffiziente Rauchsensoren zu schaffen, sind im Stand der Technik einige Sensoren bekannt, beispielswiese aus DE 10 2015 004 458 A1, EP 0 125 485, EP 0 886 252, EP 1 087 352 oder EP 3 091 517. EP 2 273 466 A1 beschreibt einen Rauchsensor mit einem Sample-and-Hold-Schaltkreis, der mit einem gepulsten Detektionssignal betrieben wird.

Aufgabe der vorliegenden Erfindung ist es, eine zuverlässige und sichere Schaltungsanordnung für einen Rauchsensor vorzuschlagen.

Gelöst wird die vorliegende Aufgabe durch eine Schaltungsanordnung gemäß Anspruch 1 sowie durch einen Verfahren gemäß Anspruch 12.

Die erfindungsgemäße Schaltungsanordnung eignet sich besonders für einen Rauchsensor mit einer Messkammer und mit einem optischen Sender, der ein Sendesignal oder Messsignal in die Messkammer aussendet. Die Schaltungsanordnung umfasst eine Photodiode zur optischen Messung von Partikeln in der Messkammer. Die Photodiode detektiert das Sendesignal, das nach Durchgang durch die Messkammer auf die Diode trifft. Die Schaltungsanordnung umfasst weiterhin einen Eingangsverstärker. Bevorzugt umfasst sie auch eine Kompensationsstromquelle, um den Dunkelstrom zu kompensieren, der am Ausgang der Photodiode anliegt, wenn kein Messsignal in die Messkammer des Rauchsensors gesendet wird.

Der Eingangsverstärker wird mit einem Eingangsstrom gespeist, der von der Photodiode erzeugt wird. Der Eingangsverstärker weist eine Rückkopplung von einem Ausgang (Eingangsverstärkerausgang) zu einem Eingang (Eingangsverstärkereingang) auf. Die Rückkopplung umfasst ein Rückkopplungsnetzwerk, das aus wenigstens einer Kapazität und wenigstens einem Schalter gebildet wird.

Erfindungsgemäß weist die Schaltungsanordnung einen Eingangsschalter auf, der zwischen der Photodiode und dem Eingangsverstärker angeordnet ist. Der Schalter ist derart platziert, dass sein Öffnen eine Entkopplung der Photodiode nach sich zieht. In diesem Fall wird der Eingangsverstärker lediglich mit einem Kompensationssignal (Kompensationsstrom) der Kompensationsstromquelle gespeist. Hierdurch lässt sich ein Testbetrieb realisieren, sodass ein Selbsttest der Schaltungsanordnung möglich ist. Beispielsweise lässt sich hierdurch der Eingangsverstärker charakterisieren. Da er eine der Rauschquellen ist und der Rauchmelder insgesamt sehr rauschempfindlich ist, kann auf diese Weise eine Kompensation des Rauscheinflusses des Eingangsverstärkers erfolgen.

Bevorzugt ist der Eingangsverstärker ein Operationsverstärker mit einem positiven und einem negativen Eingang. Ebenfalls bevorzugt erfolgt die Rückkopplung vom Eingangsverstärkerausgang zu dem negativen Eingangsverstärkereingang.

Das Rückkopplungsnetzwerk der Rückkopplungsschleife vom Ausgang des Eingangsverstärkers zum negativen Eingang weist den Vorteil auf, dass durch den Schalter die Kapazität im Rückkopplungsnetzwerk kurzgeschlossen werden kann. Damit unterscheidet sich das Rückkopplungsnetzwerk von den typischen Netzwerken, die aus einem großen Widerstand, typischerweise in der Größenordnung von 10 MΩ, und einer Kapazität gebildet werden. Anstelle des Widerstands wird ein Schalter verwendet, sodass beim Einschalten der Eingang des Eingangsverstärkers sofort auf das richtige Potential gebracht werden kann. Das Rückkopplungsnetzwerk schließt somit den negativen Eingang des Eingangsverstärkers und den Ausgang des Eingangsverstärkers zu Anfang jeder Messsequenz kurz.

Durch den Kurzschluss der Kapazitäten in dem Rückkopplungsnetzwerk werden der Eingang und Ausgang des Eingangsverstärkers sehr schnell in den richtigen Arbeitspunkt gebracht. Dieses extrem schnelle Einstellen des Arbeitspunktes bedeutet, dass eine Messung des Messsignals nach Durchgang durch die Messkammer sehr schnell erfolgen kann. Dies führt zu einer deutlich verringerten Aktivierungszeit des Rauchsensors insgesamt und somit zu einer deutlichen Ersparnis an Betriebsstrom. Auf diese Weise kann die durch die Energiequelle, beispielsweise eine Batterie, zur Verfügung gestellte Energiemenge über einen längeren Zeitraum verwendet werden. Alternativ kann bei einer vorgegebenen Betriebsdauer des Rauchsensors die Größe der Energiequelle bzw. der Batterie reduziert werden. Die Lebensdauer einer eingesetzten Batterie verdoppelt sich, bevorzugt wird sie verdreifacht, sehr bevorzugt vervierfacht gegenüber herkömmlichen und vergleichbaren Rauchsensoren.

Das Rückkopplungsnetzwerk der Schaltungsanordnung hat bevorzugt wenigstens einen Schalter, der zu der Kapazität parallelgeschaltet ist.

Ebenfalls bevorzugt ist der Schalter im Rückkopplungsnetzwerk als Transistor ausgeführt. Besonders bevorzugt wird der Schalter bzw. der Transistor getaktet.

In einer bevorzugten Ausbildung der Erfindung weist das Rückkopplungsnetzwerk wenigstens zwei Kombinationen aus Kapazität und Schalter auf, bevorzugt wenigstens drei, sehr bevorzugt wenigstens vier. Auf diese Weise lässt sich eine Abstaffelung der Kapazitäten realisieren, sodass größere Ladungsmengen integriert werden können. Die Kombinationen aus Kapazität und Schalter sind bevorzugt in parallel geschalteten Rückkopplungssträngen im Rücckopplungsnetzwerk realisiert.

In einer bevorzugten Ausführungsform weist der Eingangsverstärker eine Einschwingzeit von höchstens 1 ms, bevorzugt höchstens 500 µs, weiter bevorzugt höchstens 300 µs, weiter bevorzugt höchstens 200 µs und sehr bevorzugt höchstens 100 µs auf.

In einer bevorzugten Ausführungsform ist die Verstärkung des Eingangsverstärkers einstellbar. Sie kann durch die einzelnen Rückkopplungsstränge im Rückkopplungsnetzwerk eingestellt werden. Beispielsweise können vier parallel angeordnete Rückkopplungsstränge, die jeweils eine Kapazität, z.B. in Form eines Kondensators, und wenigstens einen Schalter umfassen, gebildet sein. Die Größe der Rückkopplungskapazitäten für die Integration des Eingangsverstärkers kann durch seriell zu den Kapazitäten im Rückkopplungszweig angeordnete Schalter eingestellt werden. Die Schalter sind bevorzugt getaktet. Bevorzugt werden die Schalter durch Transistoren aufgebaut.

Zu Beginn einer Messung schließen parallel zu den Kapazitäten angeordnete Schalter die Kapazitäten kurz und bringen dadurch den negativen Eingang des Eingangsverstärkers und den Ausgang des Eingangsverstärkers sehr schnell in den richtigen Arbeitspunkt. Die benötigte Zeitdauer, um den relevanten Arbeitspunkt zu erreichen, liegt in der Regel unter 100 µs, unter 50 µs, weiter bevorzugt unter 20 µs, weiter bevorzugt unter 10 µs, weiter bevorzugt unter 5 µs, weiter bevorzugt unter 2 µs und sehr bevorzugt unter 1 µs. Durch die kurze Reaktionszeit (Zeit bis zum Erreichen des Arbeitspunkts) lässt sich die Aktivierungszeit der Schaltungsanordnung stark reduzieren, was zu einer Betriebsstromersparnis und damit zu einer längeren Verwendung einer in einem Rauchsensor vorhandenen Energiequelle, wie beispielsweise einer Batterie führt. Bei einer Zeitdauer von kleiner 20 µs bis zum Einstellen des Arbeitspunktes lässt sich die Lebensdauer einer Batterie im Vergleich zu bekannten Rauchsensoren vervierfachen, bei einer Zeitdauer kleiner 100 µs verdoppeln.

Die Kompensationsstromquelle ist bevorzugt eine sogenannte Dunkelstromquelle. Sie erzeugt einen Strom, der zur Kompensation des sogenannten Dunkelstroms verwendet wird. Der Dunkelstrom ist dabei der Strom, der in der Schaltungsanordnung fließt, wenn kein Messsignal (Sendesignal) in die Messkammer gesendet und kein Messsignal von der Photodiode empfangen wird. Der Dunkelstrom wird also durch das Umgebungslicht des Rauchsensors hervorgerufen. Mittels der Dunkelstromquelle lässt sich dieses Signal kompensieren, sodass es bevorzugt keinen oder einen sehr geringen Einfluss auf die Messung hat.

In einer bevorzugten Ausführungsform weist die Schaltungsanordnung wenigstens einen weiteren Verstärker auf, bevorzugt einen ersten und optional einen zweiten Verstärker. Die beiden Verstärker sind mit dem Eingangsverstärker in Reihe geschaltet und verarbeiten das Ausgangssignal des Eingangsverstärkers weiter. Bevorzugt hat der erste und/oder der zweite Verstärker eine einstellbare Verstärkung.

Die beiden Verstärker (erster Verstärker und zweiter Verstärker) können gemeinsam mit dem Eingangsverstärker dazu verwendet werden, eine Subtraktion zwischen dem sogenannten Hellstrom (Messstrom, bei Anlegen eines Messsignals, plus Dunkelstrom) und dem Dunkelstrom durchzuführen. Beispielsweise ist dies sinnvoll, wenn nicht die gesamten Umgebungseinflüsse, insbesondere das Umgebungslicht, durch die Kompensationsstromquelle kompensiert werden kann. Bevorzugt erfolgt die Subtraktion mittels des ersten und/oder des zweiten Verstärkers.

Beispielsweise kann der erste Verstärker als Operationsverstärker ausgeführt sein. An seinen beiden Eingängen kann jeweils eine Kapazität vorgesehen sein. Vorteilhaft weist der negative Eingang des ersten Verstärkers einen Kondensator auf. In diesem wird die Ladungsmenge aus dem Eingangsverstärker gespeichert, die durch den Dunkelstrom und den Messstrom, also durch den Hellstrom, erzeugt wurde. Der Eingangsverstärker arbeitet dabei als Integrator, sodass die integrierte Ladungsmenge in dem ersten Kondensator am negativen Eingang des ersten Verstärkers gespeichert wird. Bevorzugt ist am positiven Eingang des ersten Verstärkers ein Kondensator angeordnet, in dem die Ladungsmenge aus dem Eingangsverstärkers gespeichert wird, die lediglich durch den Dunkelstrom, also ohne Messstrom, erzeugt wurde. Eine bevorzugte Kompensationsstromquelle kann zusätzlich verwendet werden. In diesem Fall wird die Differenz zwischen Hellstrom und Dunkelstrom gebildet, die nicht durch die Kompensationsstromquelle kompensiert wird.

Die Messung des sich aus der Subtraktion ergebenden Messstroms erfolgt in drei zeitlich nacheinander folgenden Phasen. In der ersten Phase wird der Dunkelstrom und der Messstrom im Eingangsverstärker integriert und dann im Kondensator am negativen Eingang des ersten Verstärkers gespeichert. In einer zweiten Messphase wird nur der Dunkelstrom im Eingangsverstärker integriert und in dem Kondensator am positiven Eingang des ersten Verstärkers gespeichert. In einer dritten Messphase wird ein zwischen den beiden Kondensatoren angeordneter Schalter geschlossen, wodurch eine Differenzbildung hervorgerufen wird.

In einer bevorzugten Ausführungsform dient der zweite Verstärker als analoge Speicherstufe. Sie kann den gemessenen Messstrom zwischenspeichern und für einen am Ausgang des zweiten Verstärkers angeordneten optionalen Digitalanalogwandler zur Verfügung stellen. Besonders bevorzugt ist der Analog-Digital-Wandler ein 10 Bit-Analog-Digital-Wandler. Selbstverständlich ist es auch möglich, einen 8 Bit-, einen 4 Bit- oder einen 16 Bit-Analog-Digital-Wandler zu verwenden.

In einer bevorzugten Ausführungsform weisen der erste Verstärker und/oder der zweite Verstärker ebenfalls ein Rückkopplungsnetzwerk auf.

In einer bevorzugten Ausführungsform hat die Schaltungsanordnung eine Spannungsquelle, die am Ausgang des zweiten Verstärkers angeordnet ist. Die Spannungsquelle kann eine sehr geringe Spannung zur Verfügung stellen, beispielsweise reichen in der praktischen Anwendung häufig eine Spannung von 200 mV, bevorzugt 100 mV, sehr bevorzugt 50 mV. Diese Spannung wird verwendet, um den Nullwert messen zu können. Somit ist es möglich, auch negative Ströme zu messen. Bevorzugt ist die Spannungsquelle am Ausgang des zweiten Verstärkers regelbar. Damit können auch niedrigere Spannungen (0 mV bis 50 mV) oder höhere Spannungen von bis zu 250 mV, bevorzugt bis zu 300 mV erzeugt werden.

In einer bevorzugten Ausführungsform hat die Schaltungsanordnung vor dem Eingangsverstärker einen Bandpassfilter oder besonders bevorzugt einen Tiefpassfilter. Der Filter umfasst eine Kombination aus Widerständen und Kondensatoren sowie wenigstens einen Schalter, der im Normalbetrieb hochohmig ist.

Vorteilhafterweise wird ein Tiefpassfilter verwendet. Dieser wirkt gemeinsam mit dem Verstärker und der sich ergebenden Differenzbildung wie ein Bandpassfilter, da die Differenzbildung den Gleichspannungsanteil bei der Frequenz f=0 Hz eliminiert.

Zusammenfassend kann festgehalten werden, dass die erfindungsgemäße Schaltungsanordnung den wesentlichen Vorteil bietet, dass der Eingangsverstärker deutlich schneller einschwingt als bei herkömmlichen Schaltungen für Rauchsensoren. Dies wird durch die Verbindungsmöglichkeit zwischen Eingang (negativer Eingang) des Eingangsverstärkers und dessen Ausgang realisiert. Da in dem Rückkopplungsnetzwerk Schalter und Kondensatoren vorgesehen sind, kann der Arbeitspunkt quasi sofort erreicht werden. Dies führt zu schnelleren Messungen und damit zu einer geringeren Aktivzeit des Rauchsensors. Hieraus ergibt sich eine deutlich geringere Stromaufnahme im Betrieb, was ein wesentlicher Faktor ist für eine längere Laufzeit der zur Verfügung stehenden Batterie bzw. Energiequelle.

Ein weiterer Vorteil ist, dass die Schaltungsanordnung einen sehr niedrigen Rauschpegel aufweist. Ursachen für den Rauschpegel sind in dem als Operationsverstärker ausgebildeten Eingangsverstärker sowie in dem Photostrom (Messstrom) zu sehen. Das 1/f-Rauschen wird durch die Differenzbildung und die Abtastung mit hoher Frequenz eliminiert. Die sich damit ergebende hohe Geschwindigkeit des Eingangsverstärkers ist für das relevante 1/f-Rauschen in einen höherfrequenten Teil verschoben und daher besonders gering. Diese Verschiebung und die Differenzbildung führen zu einem guten Signal-Rauschverhältnis.

Da in einer bevorzugten Ausführungsform die Eingangstransistoren des Eingangsverstärkers relativ groß gewählt werden können, ist das Rauschen des Eingangsverstärkers klein. Die Transistoren haben bevorzugt ein W/L-Verhältnis von 40:1. Andere W/L Verhältnisse wie beispielsweise 160:1 oder 10:1 sind möglich. Bevorzugt sind W/L-Verhältnisse von 5:1 bis 200:1, besonders bevorzugt von 10:1 bis 100:1, sehr bevorzugt von 30:1 bis 50:1.

Im Rahmen der Erfindung hat sich gezeigt, dass in dem konkreten Anwendungsfall (des Rauchsensors) dieses W/L-Verhältnis von 40:1 besonders günstig ist. Andere Anwendungsfälle können ein anders W/L-Verhältnis als vorteilhaft erfordern. Für die Nacharbeit ist die Simulation des Gesamtsystems zur Optimierung des W/L-Verhältnisses und der anderen Schaltungsteile an den konkreten Anwendungsfall vorteilhaft. Unter dem W/L Verhältnis eines MOS-Transistors wird in diesem Zusammenhang die Breite des leitenden elektrischen Kanals unter der Steuerelektrode, dem Gate des MOS-Transistors, im Verhältnis zur Länge des elektrisch leitenden Kanals unter der Steuerelektrode, dem Gate, vom Source-Anschluss des MOS-Transistors zum Drain-Anschluss des MOS-Transistors verstanden.

Die gestellte Aufgabe wird auch durch ein Verfahren gemäß Anspruch 12 gelöst. Das Verfahren ermöglicht die Durchführung eines Testbetriebs der oben beschriebenen Schaltung.

Ein optionales zusätzliches Verfahren dient zur Verkürzung der Messzeit einer Schaltungsanordnung mit einer Photodiode und einem Verstärker, der bevorzugt ein Operationsverstärker ist. Der Verstärker hat eine Rückkopplung von seinem Ausgang zu einem Eingang des Verstärkers. Die Rückkopplung umfasst ein Rückkopplungsnetzwerk, das wenigstens eine Kapazität und einen Rückkopplungsschalter umfasst, der bevorzugt parallel zu der Kapazität angeordnet ist.

Dabei umfasst dieses Verfahren das Schließen des Rückkopplungsschalters für eine vordefinierte erste Zeitspanne. Während dieser Zeitspanne wird die Kapazität entladen. Sobald der Verstärker in seinem Arbeitspunkt ist, erfolgt das Öffnen des Rückkopplungsschalters. Es wird also mit dem Öffnen gewartet, bis der Arbeitspunkt erreicht ist. In einem weiteren Schritt wird ein erster Strom der Photodiode gemessen. Dies erfolgt für eine vordefinierte zweite Zeitspanne.

Beispielsweise sendet ein Sender wenigstens während eines Teils der zweiten Zeitspanne ein Signal, das von der Photodiode detektiert wird. Bei Einsatz der Schaltungsanordnung in einem Rauchsensor mit Messkammer sendet der Sender das Signal in eine Messkammer des Sensors und wird dort detektiert von der Photodiode.

Die erste und zweite Zeitspanne sind jeweils kleiner 100 µs, bevorzugt ist die zweite Zeitspanne kleiner als die erste Zeitspanne. In einer bevorzugten Ausführungsform ist die erste Zeitspanne höchstens 50 µs, bevorzugt höchstens 40 µs, weiter bevorzugt höchstens 25 µs, sehr bevorzugt höchstens 20 µs.

Die zweite Zeitspanne ist bevorzugt kleiner als 60 µs, weiter bevorzugt kleiner als 50 µs, weiter bevorzugt kleiner als 40 µs und sehr bevorzugt kleiner als 25 µs ist. Bevorzugt ist der erste Strom der Hellstrom.

Das zusätzliche Verfahren umfasst weitere Schritte. Ein Verfahrensschritt ist das Schließen des Rückkopplungsschalters für eine vordefinierte dritte Zeitspanne. Ein weiterer Schritt umfasst das Warten bis der Verstärker in seinem Arbeitspunkt ist. Der Rückkopplungsschalters wird dann geöffnet. Messen eines zweiten Stroms der Photodiode für eine vordefinierte vierte Zeitspanne ist ein weiterer Schritt, ebenso wie die Differenzbildung zwischen dem ersten Strom und dem zweiten Strom innerhalb einer fünften Zeitspanne.

Die dritte Zeitspanne und die vierte Zeitspanne sind kleiner als 100 µs und die fünfte Zeitspanne kleiner als 100 µs. Besonders bevorzugt ist die dritte Zeitspanne höchstens 50 µs, weiter bevorzugt höchstens 30 µs, sehr bevorzugt höchstens 20 µs lang. Die vierte Zeitspanne ist bevorzugt höchstens 50 µs. Bevorzugt ist die fünfte Zeitspanne höchstens 60 µs; sie kann eine AD-Wandlung umfassen.

Bevorzugt wird während der vierten Zeitspanne, in der die Messung des zweiten Stroms der Photodiode erfolgt, kein zusätzliches optisches Signal, beispielsweise in die Messkammer eines Rauchsensors, gesendet.

Die vierte Zeitspanne ist bevorzugt kleiner als 60 µs, weiter bevorzugt kleiner als 50 µs, weiter bevorzugt kleiner als 40 µs und sehr bevorzugt kleiner als 25 µs ist. Bevorzugt kann die vierte Zeitspanne kleiner oder gleich der zweiten Zeitspanne sein.

Die Erfindung wird nachfolgend anhand von Figuren näher erläutert. Die hierbei dargestellten Besonderheiten und Merkmale können einzeln oder in einer anderen Kombination als hier beschrieben verwendet werden. Es zeigen:
- Figur 1: eine schematische Darstellung eines Rauchsensors;
- Figur 2: eine erfindungsgemäße Schaltungsanordnung zur Detektion eines durch eine Messkammer laufenden Messsignals;
- Figur 3: ein Rückkopplungsnetzwerk eines Eingangsverstärkers der Schaltungsanordnung aus Figur 2; und
- Figur 4: eine Messkurve einer Messung mit der Schaltungsanordnung aus Figur 2.

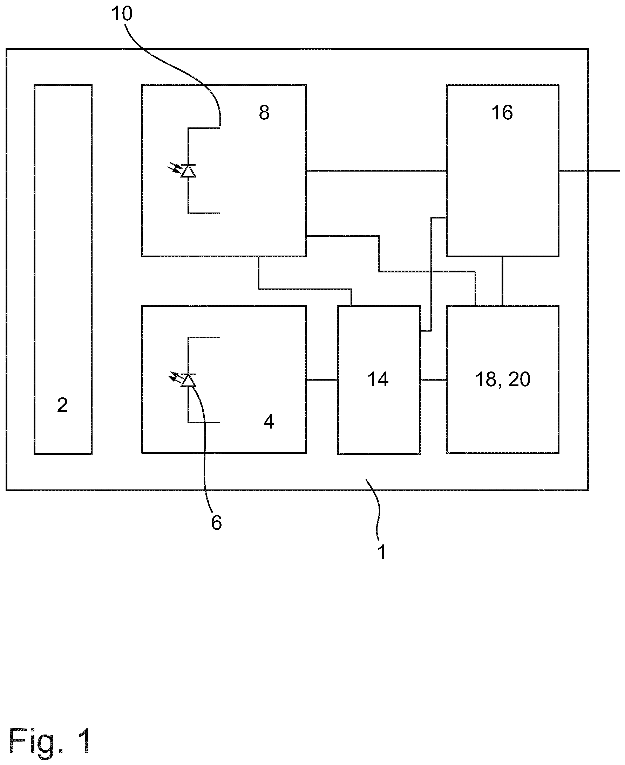

Figur 1 zeigt eine schematische Darstellung eines Rauchsensors 1 mit einer Messkammer 2, einer Sendeeinheit 4, die einen optischen Sender 6 umfasst, der ein Messsignal (Sendesignal) in die Messkammer 2 aussendet. Der Rauchsensor 1 umfasst weiter eine Messeinheit 8, die als Schaltungsanordnung 10 bezeichnet wird und eine Photodiode 12 sowie mehrere Verstärker umfasst. Der Rauchsensor 1 weist eine Steuereinheit 14 zur Steuerung der einzelnen Komponenten, eine Auswerteeinheit 16 zum Auswerten eines Ausgangssignals der Messeinheit 8 und eine als Batterie 18 ausgebildete Spannungsquelle 20 auf. Die Steuereinheit 14 stellt die Sendeeinheit 4 und die Messeinheit 8 ein und regelt sie entsprechend.

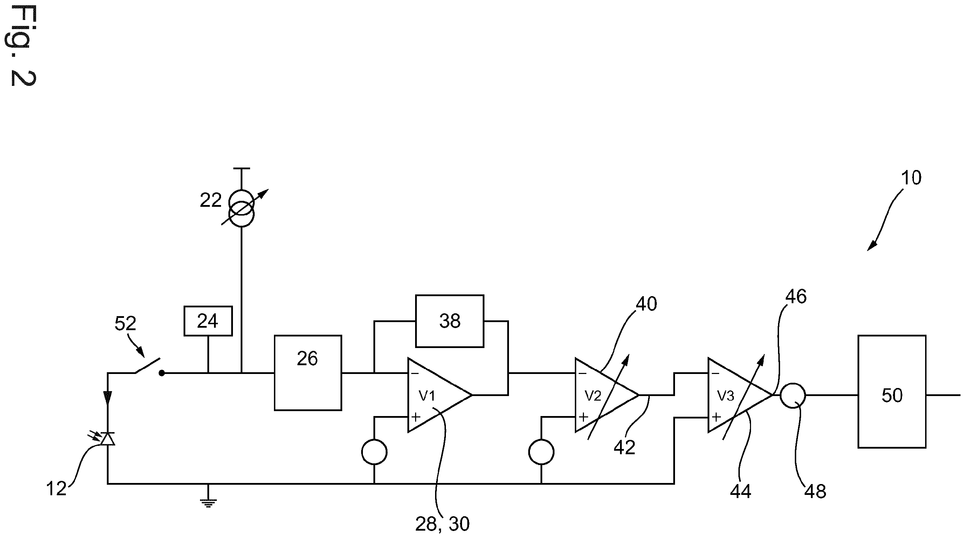

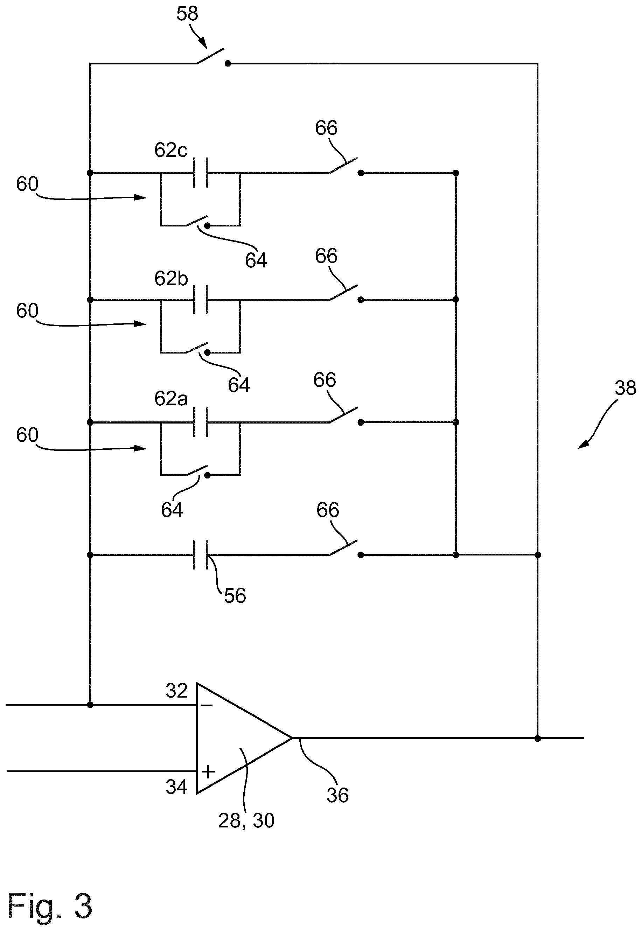

Figur 2 zeigt eine schematische Detailansicht einer erfindungsgemäßen Schaltungsanordnung 10. Die Schaltungsanordnung 10 umfasst neben der Photodiode 12 eine Kompensationsstromquelle 22, die als Dunkelstromquelle bezeichnet wird. Am Ausgang der Photodiode 12 kann eine optionale Schutzschaltung 24 angeordnet sein, die einen Schutz gegen elektrostatische Entladung bilden kann. Ein Filter 26, der als Bandfassfilter oder als Tiefpassfilter ausgebildet sein kann, ist zwischen der Photodiode 12 und einem Eingangsverstärker 28 angeordnet. Der Eingangsverstärker 28 ist bevorzugt als Operationsverstärker 30 ausgebildet. Ein negativer Eingang 32 des Eingangsverstärkers 28 bzw. Operationsverstärkers 30 ist mit dem Filter 26 verbunden. Ein positiver Eingang 34 des Operationsverstärkers ist über eine Spannungsquelle mit Masse verbunden. Ein Ausgang 36 des Operationsverstärkers ist über ein Rückkopplungsnetzwerk 38 mit dem negativen Eingang 32 verbunden. Das Rückkopplungsnetzwerk 38 wird in Figur 3 im Detail erläutert.

Der Ausgang 36 des Eingangsverstärkers 28 ist mit einem ersten Verstärker 40 verbunden, an dessen Ausgang 42 ein zweiter Verstärker 44 angeordnet ist. Am Ausgang 46 ist eine Spannungsquelle 48 vorgesehen, die eine Offsetspannung zur Verfügung stellt. Damit können auch negative Ströme in der Schaltungsanordnung 10 gemessen werden. Ein Analog-Digital-Wandler 50 (ADC) ist ebenfalls am Ausgang 46 des zweiten Verstärkers 44 angeordnet. Er liefert den Messwert, der eine charakteristische Größe darstellt, um Rauch innerhalb der Messkammer 2 zu detektieren.

Der erfindungsgemässe Eingangsschalter 52 zwischen der Photodiode 12 und der Schutzschaltung 24 ermöglicht es, die Photodiode 12 von der Verstärkerschaltung zu entkoppeln. In diesem Fall wird der Eingangsverstärker 28 lediglich von der Kompensationsstromquelle 22 gespeist. Auf diese Weise lässt sich ein Testbetrieb realisieren, um die Schaltung ohne Photodiode (12) zu vermessen. Beispielsweise lässt sich hierdurch das Rauschen der Schaltung bestimmen.

Der Eingangsverstärker 28, der als Operationsverstärker 30 ausgebildet ist, ist bevorzugt als Transimpedanzverstärker mit einer Rückkopplung zwischen Ausgang 36 und negativem Eingang 32 verschaltet. Er ist somit ein kapazitiver Integrator.

Die beiden Verstärker 40, 44 weisen eine einstellbare Verstärkung auf. Dies kann durch eine hier nicht dargestellte Rückkopplung mit einem Netzwerk, das jeweils wenigstens eine Kapazität umfasst, eingestellt werden. Bevorzugt hat das Netzwerk mehrere Kapazitäten und Schalter, um die Verstärkung zu variieren.

Figur 3 zeigt das Rückkopplungsnetzwerk 38 mit dem Operationsverstärker 30 als Eingangsverstärker 28. Das Rückkopplungsnetzwerk 38 ist zwischen Ausgang 36 und negativem Eingang 32 angeordnet.

Das Rückkopplungsnetzwerk umfasst im Wesentlichen eine S-C-Kombination (Switch-Capacitor-Kombination), die eine Rückkopplungskapazität 56 und einen Rückkopplungsschalter 58 umfasst, wobei der Rückkopplungsschalter 58 die Rückkopplungskapazität 56 kurzschließen kann, sodass die Rückkopplungskapazität 56 entladen wird.

In der hier gezeigten Ausführungsform sind der Rückkopplungskapazität 56 drei weitere S-C-Kombinationen parallelgeschaltet, die jeweils aus einer Kapazität 62a, 62b, 62c und je einem parallelen Schalter 64 bestehen. Mittels je eines seriellen Schalters 66 können die einzelnen S-C-Kombinationen 60 zugeschaltet werden. Auf diese Weise lässt sich die Verstärkung des Operationsverstärkers 30 einstellen. Typische Werte für die Rückkopplungskapazität 56 und die Kapazitäten 62 sind beispielsweise 1 Pikofarad (pF) für die Rücckopplungskapazität 56 und 1 pF, 2 pF bzw. 4 pF für die Kapazitäten 62a, 62b bzw. 62c. Die Schalter 64, 66 und der Rückkopplungsschalter 58 sind bevorzugt getaktet; besonders bevorzugt sind sie Transistoren.

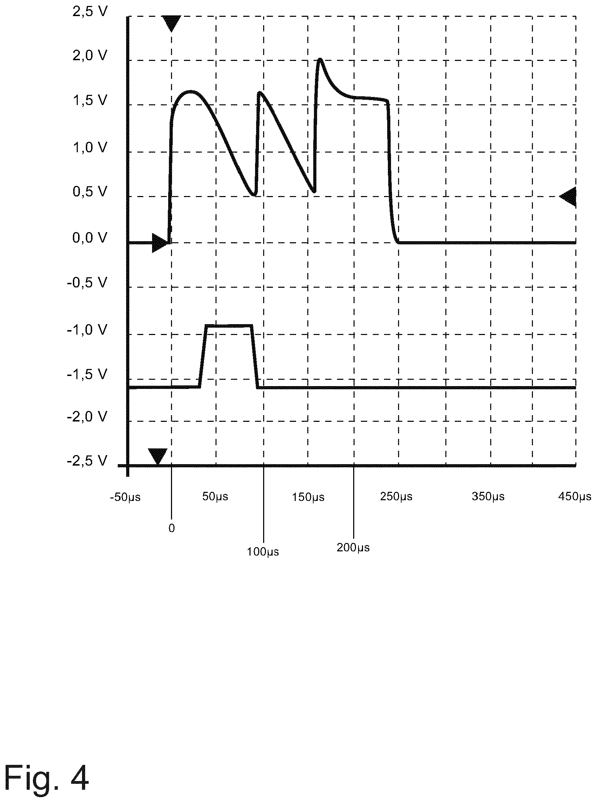

Figur 4 zeigt den zeitlichen Verlauf der Spannung an der Photodiode 12 (oben) und von dem optischen Sender 6 abgegebenen Spannung (unten), wobei der optische Sender beispielsweise eine LED sein kann. Der optische Sender 6 kann im sichtbaren oder nicht sichtbaren Bereich Licht aussenden, das von der Photodiode 12 empfangen wird.

Während einer Zeitspanne von 0 bis 40 µs ist der Kurzschlussschalter aktiv, d.h. der Rückkopplungsschalter 58 ist geschlossen. Es findet ein Nullabgleich statt.

Während der Zeitdauer von 40 µs bis 90 µs wird ein Messsignal vom Sender 6 gesendet. Es erfolgt eine Messung des Hellstroms, der den Messstrom und den Dunkelstrom umfasst, d.h. der Messstrom und der Dunkelstrom werden gemeinsam detektiert.

In der Zeitspanne von 90 µs bis 110 µs (Sender 6 ist ausgeschaltet) ist der Kurzschlussschalter erneut aktiviert, was zu einem weiteren Nullabgleich führt.

Von 110 µs bis 160 µs erfolgt die Messung des Dunkelstroms allein, nachdem der Sendeimpuls des Senders 6 abgeschaltet wurde.

Während einer Zeitdauer von 160 µs bis 230 µs erfolgt die Differenzbildung zwischen dem Hellstrom, der den Messstrom und Dunkelstrom umfasst, und dem Dunkelstrom alleine mittels eines Sample-and-Hold-Verfahrens und einer anschließend Analog-Digital-Wandlung. Somit zeigt sich, dass die Messung und Detektion von Rauch oder anderen Partikeln in der Messkammer innerhalb von weniger als 200 µs erfolgt, im gezeigten Beispiel innerhalb von 160 µs. Auch die Differenzbildung und Auswertung des Messsignals innerhalb von 70 µs ist sehr schnell, was zu einem deutlich reduzierten Energiebedarf der Schaltungsanordnung und somit des gesamten Rauchsensors führt.

## Patentansprüche

1. Schaltungsanordnung für einen Rauchsensor mit einer Messkammer (2) und einem optischen Sender (6), der ein Messsignal in die Messkammer (2) aussendet, umfassend
- eine Photodiode (12) zur optischen Messung von Partikeln in der Messkammer (2), und
- einen Eingangsverstärker (28),
wobei
- der Eingangsverstärker (28) mit einem von der Photodiode (12) erzeugten Eingangsstrom gespeist wird,
- der Eingangsverstärker (28) eine Rückkopplung von einem Ausgang (36) des Eingangsverstärkers zu einem Eingang (32) des Eingangsverstärkers aufweist, wobei die Rückkopplung ein Rückkopplungsnetzwerk (38) umfasst, das aus wenigstens einer Kapazität (56) und wenigstens einem Schalter (58) gebildet wird;
**dadurch gekennzeichnet, dass**
die Schaltungsanordnung (10) einen Eingangsschalter (52) umfasst, um die Photodiode (12) vom Eingangsverstärker (28) zu trennen und um einen Testbetrieb zu ermöglichen, in dem der Eingangsverstärker (28) nur von einer Kompensationsstromquelle (22) gespeist wird.

2. Schaltungsanordnung nach Anspruch 1, **dadurch gekennzeichnet, dass** am Ausgang der Photodiode (12) eine Schutzschaltung (24) angeordnet ist, die einen Schutz gegen elektrostatische Entladung bilden kann, wobei der Eingangsschalter (52) zwischen dem Ausgang der Photodiode und der Schutzschaltung (24) angeordnet ist.

3. Schaltungsanordnung nach Anspruch 1 oder 2, **dadurch gekennzeichnet, dass** das der Schalter (58) zu der Kapazität (56) parallel geschaltet ist.

4. Schaltungsanordnung nach einem der vorhergehenden Ansprüche, **dadurch gekennzeichnet, dass** der Schalter (58) als Transistor realisiert ist, der bevorzugt getaktet wird.

5. Schaltungsanordnung nach einem der vorhergehenden Ansprüche, **dadurch gekennzeichnet, dass** das Rückkopplungsnetzwerk (38) wenigstens zwei Kombinationen aus Kapazität (56, 62) und Schalter (58, 66) umfasst, bevorzugt wenigstens drei Kombinationen.

6. Schaltungsanordnung nach einem der vorhergehenden Ansprüche, **dadurch gekennzeichnet, dass** der Eingangsverstärker (28) eine Einschwingzeit von <1 ms hat, bevorzugt <500 µs, weiter bevorzugt <300 µs, sehr bevorzugt <200 µs.

7. Schaltungsanordnung nach einem der vorhergehenden Ansprüche, **dadurch gekennzeichnet, dass** die Kompensationsstromquelle (22) eine Dunkelstromquelle ist, die einen Strom erzeugt, der zur Kompensation eines Dunkelstroms dient, wobei der Dunkelstrom der Strom ist, der in der Schaltungsanordnung (10) fließt, wenn kein Messsignal in die Messkammer (2) gesendet wird.

8. Schaltungsanordnung nach einem der vorherigen Ansprüche, **dadurch gekennzeichnet, dass** die Schaltungsanordnung (10) einen ersten Verstärker (40) und optional einen zweiten Verstärker (44) umfasst, die mit dem Eingangsverstärker (28) in Reihe geschaltet sind und das Ausgangssignal des Eingangsverstärkers (28) weiterverarbeiten.

9. Schaltungsanordnung nach Anspruch 8, **dadurch gekennzeichnet, dass** der erste Verstärker (40) und/oder der zweite Verstärker (44) eine einstellbare Verstärkung aufweisen.

10. Schaltungsanordnung nach Anspruch 8 oder 9, **dadurch gekennzeichnet, dass** eine Kompensation des Dunkelstroms durch eine Subtraktion zwischen dem auf dem Messsignal beruhenden Hellstrom und dem Dunkelstrom, wenn kein Messsignal gesendet wird, am Ausgang (36) des Eingangsverstärkers (28), bevorzugt mittels des ersten Verstärkers (40) und/oder des zweiten Verstärkers (44), erfolgt.

11. Rauchsensor mit einer Messkammer, **dadurch gekennzeichnet, dass** der Rauchsensor (1) eine Schaltungsanordnung (10) nach einem der vorherigen Ansprüche und eine Batterie (18) sowie einen optischen Sender (6), der ein Messsignal in die Messkammer (2) aussendet, umfasst.

12. Verfahren zum Testen einer Schaltungsanordnung für einen Rauchsensor, mit einer Photodiode (12) und einem Eingangsverstärker (28), bevorzugt mit einem Operationsverstärker (30), wobei der Eingangsverstärker mit einem von der Photodiode (12) erzeugten Eingangsstrom gespeist wird und eine Rückkopplung von seinem Ausgang zu einem Eingang des Eingangsverstärker hat und die Rücckopplung ein Rückkopplungsnetzwerk aufweist, das wenigstens eine Kapazität und einen Rückkopplungsschalter (58) umfasst, und wobei die Schaltungsanordnung (10) eine Kompensationsstromquelle (22) aufweist und weiters einen Eingangsschalter (52) umfasst, um die Photodiode (12) vom Eingangsverstärker (28) zu trennen, umfassend die folgenden Schritte:
- Öffnen des Eingangsschalters (52);
- Trennen der Photodiode (12) von dem Eingangsverstärker (28);
- Starten eines Testbetriebs;
- Speisen des Eingangsverstärkers (28) von der Kompensationsstromquelle (22).

## Claims

1. Circuit arrangement for a smoke sensor with a measuring chamber (2) and an optical transmitter (6) which transmits a measuring signal into the measuring chamber (2), comprising
- a photodiode (12) for the optical measurement of particles in the measuring chamber (2), and
- an input amplifier (28),
wherein
- the input amplifier (28) is fed with an input current generated by the photodiode (12),
- the input amplifier (28) has a feedback from an output (36) of the input amplifier to an input (32) of the input amplifier, the feedback comprising a feedback network (38) formed by at least one capacitance (56) and at least one switch (58);
**characterized in that**
the circuit arrangement (10) comprises an input switch (52) to disconnect the photodiode (12) from the input amplifier (28) and to enable a test mode in which the input amplifier (28) is only fed by a compensation current source (22).

2. Circuit arrangement according to claim 1, **characterized in that** a protective circuit (24) is arranged at the output of the photodiode (12), which protective circuit can provide protection against electrostatic discharge, wherein the input switch (52) is arranged between the output of the photodiode and the protective circuit (24).

3. Circuit arrangement according to claim 1 or 2, **characterized in that** the switch (58) is connected in parallel with the capacitance (56).

4. Circuit arrangement according to any one of the preceding claims, **characterized in that** the switch (58) is implemented as a transistor which is preferably clocked.

5. Circuit arrangement according to any one of the preceding claims, **characterized in that** the feedback network (38) comprises at least two combinations of capacitance (56, 62) and switch (58, 66), preferably at least three combinations.

6. Circuit arrangement according to any one of the preceding claims, **characterized in that** the input amplifier (28) has a settling time of <1 ms, preferably <500 µs, more preferably <300 µs, very preferably <200 µs.

7. Circuit arrangement according to any one of the preceding claims, **characterized in that** the compensation current source (22) is a dark current source which generates a current which serves to compensate for a dark current, the dark current being the current which flows in the circuit arrangement (10) when no measuring signal is sent into the measuring chamber (2).

8. Circuit arrangement according to any one of the preceding claims, **characterized in that** the circuit arrangement (10) comprises a first amplifier (40) and optionally a second amplifier (44), which are connected in series with the input amplifier (28) and which further process the output signal of the input amplifier (28).

9. Circuit arrangement according to claim 8, **characterized in that** the amplification of the first amplifier (40) and/or the second amplifier (44) can be adjusted.

10. Circuit arrangement according to claim 8 or 9, **characterized in that** a compensation of the dark current is carried out by a subtraction between the light current based on the measurement signal and the dark current, if no measurement signal is sent, at the output (36) of the input amplifier (28), preferably by means of the first amplifier (40) and/or the second amplifier (44).

11. Smoke sensor with a measuring chamber, **characterized in that** the smoke sensor (1) comprises a circuit arrangement (10) according to any one of the preceding claims as well as a battery (18) and an optical transmitter (6) which sends a measuring signal into the measuring chamber (2).

12. Method for testing a circuit arrangement for a smoke sensor, with a photodiode (12) and an input amplifier (28), preferably with an operational amplifier (30), wherein the input amplifier is fed with an input current generated by the photodiode (12) and has feedback from its output to an input of the input amplifier, and the feedback comprises a feedback network which comprises at least one capacitance and one feedback switch (58), and wherein the circuit arrangement (10) comprises a compensation current source (22) and further comprises an input switch (52) to disconnect the photodiode (12) from the input amplifier (28), comprising the following steps:
- opening the input switch (52);
- disconnecting the photodiode (12) from the input amplifier (28);
- starting a test mode;
- feeding the input amplifier (28) from the compensation current source (22).

## Revendications

1. Arrangement de circuit pour un détecteur de fumée avec une chambre de mesure (2) et un émetteur optique (6), qui émet un signal de mesure vers la chambre de mesure (2), comprenant
- une photodiode (12) pour la mesure optique de particules dans la chambre de mesure (2) et
- un amplificateur d'entrée (28),
dans lequel
- l'amplificateur d'entrée (28) est alimenté avec un courant d'entrée généré par la photodiode (12),
- l'amplificateur d'entrée (28) comprend un couplage de retour d'une sortie (36) de l'amplificateur d'entrée vers une entrée (32) de l'amplificateur d'entrée, dans lequel le couplage de retour comprend un réseau de couplage de retour (38) qui est constitué d'au moins un condensateur (56) et d'au moins un commutateur (58) ;
**caractérisé en ce que**
l'arrangement de circuit (10) comprend un commutateur d'entrée (52) afin de séparer la photodiode (12) de l'amplificateur d'entrée (28) et de permettre un mode de fonctionnement de test dans lequel l'amplificateur d'entrée (28) est alimenté uniquement par une source de courant de compensation (22).

2. Arrangement de circuit selon la revendication 1, **caractérisé en ce que**, à la sortie de la photodiode (12), est disposé un circuit de protection (24) qui permet de former une protection contre une décharge électrostatique, dans lequel le commutateur d'entrée (52) est disposé entre la sortie de la photodiode et le circuit de protection (24).

3. Arrangement de circuit selon la revendication 1 ou 2, **caractérisé en ce que** le commutateur (58) est branché en parallèle par rapport au condensateur (56).

4. Arrangement de circuit selon l'une des revendications précédentes, **caractérisé en ce que** le commutateur (58) est conçu comme un transistor qui est de préférence cadencé.

5. Arrangement de circuit selon l'une des revendications précédentes, **caractérisé en ce que** le réseau de couplage de retour (38) comprend au moins deux combinaisons constituées d'un condensateur (56, 62) et d'un commutateur (58, 66), de préférence d'au moins trois combinaisons.

6. Arrangement de circuit selon l'une des revendications précédentes, **caractérisé en ce que** l'amplificateur d'entrée (28) présente un temps de stabilisation < 1 ms, de préférence < 500 µs, notamment < 300 µs, tout particulièrement < 200 µs.

7. Arrangement de circuit selon l'une des revendications précédentes, **caractérisé en ce que** la source de courant de compensation (22) est une source de courant d'obscurité qui génère un courant permettant de compenser un courant d'obscurité, dans lequel le courant d'obscurité est le courant qui s'écoule dans l'arrangement de circuit (10) lorsqu'aucun signal de mesure n'est émis vers la chambre de mesure (2).

8. Arrangement de circuit selon l'une des revendications précédentes, **caractérisé en ce que** l'arrangement de circuit (10) comprend un premier amplificateur (40) et, en option, un deuxième amplificateur (44), qui sont branchés en série avec l'amplificateur d'entrée (28) et qui traitent le signal de sortie de l'amplificateur d'entrée (28).

9. Arrangement de circuit selon la revendication 8, **caractérisé en ce que** le premier amplificateur (40) et/ou le deuxième amplificateur (44) présentent une amplification réglable.

10. Arrangement de circuit selon la revendication 8 ou 9, **caractérisé en ce qu'**une compensation du courant d'obscurité a lieu à l'aide d'une soustraction entre le courant de clarté reposant sur le signal de mesure et le courant d'obscurité lorsqu'aucun signal de mesure n'est émis, à la sortie (36) de l'amplificateur d'entrée (28), de préférence au moyen du premier amplificateur (40) et/ou du deuxième amplificateur (44).

11. Détecteur de fumée avec une chambre de mesure, **caractérisé en ce que** le détecteur de fumée (1) comprend un arrangement de circuit (10) selon l'une des revendications précédentes et une batterie (18) ainsi qu'un émetteur optique (6), qui émet un signal de mesure vers la chambre de mesure (2).

12. Procédé de test d'un arrangement de circuit pour un détecteur de fumée, avec une photodiode (12) et un amplificateur d'entrée (28), de préférence avec un amplificateur opérationnel (30), dans lequel l'amplificateur d'entrée est alimenté avec un courant d'entrée généré par la photodiode (12) et comprend un couplage de retour de sa sortie vers une entrée de l'amplificateur d'entrée et le couplage de retour comprend un réseau de couplage de retour qui comprend au moins un condensateur et un commutateur de couplage de retour (58) et dans lequel l'arrangement de circuit (10) comprend une source de courant de compensation (22) et en outre un commutateur d'entrée (52), afin de séparer la photodiode (12) de l'amplificateur d'entrée (28), comprenant les étapes suivantes :
- ouverture du commutateur d'entrée (52) ;
- séparation de la photodiode (12) de l'amplificateur d'entrée (28) ;
- démarrage d'un mode de test ;
- alimentation de l'amplificateur d'entrée (28) par la source de courant de compensation (22).
